# EUROPÄISCHE PATENTSCHRIFT

(11) **EP 0 364 618 B1**
(45) Veröffentlichungstag und Bekanntmachung des Hinweises auf die Patenterteilung: **13.10.1993**
(21) Anmeldenummer: 88117313.2
(22) Anmeldetag: 18.10.1988
(51) Int. Cl.: H05K 7/14

(54) **Mehrfachsignalübertragungsgerät**
Multiple signal transmission device
Appareil de transmission de signal multiple

(43) Veröffentlichungstag der Anmeldung: 25.04.1990
(73) Patentinhaber: Weidmüller Interface GmbH & Co., D-32760 Detmold (DE)
(72) Erfinder: Beer, Dieter, D-8759 Mösbach/Feldkahl (DE); Reddehase, Horst, D-4930 Detmold (DE); Kerbstat, Siegfried, D-4930 Detmold (DE); Hanning, Detlef, D-4936 Augustdorf (DE); Plass, Ulrich, D-4930 Detmold (DE); Krause, Hermann, D-4930 Detmold (DE)
(74) Vertreter: Stracke, Alexander, Dipl.-Ing.

(56) Entgegenhaltungen:
- EP-A- 0 004 507
- EP-A- 0 236 711
- EP-A- 0 272 189
- US-A- 4 558 914

## Beschreibung

Die vorliegende Erfindung betrifft ein Mehrfachsignalübertragungsgerät mit einem vom Netz speisbaren Sender bzw. Empfänger und Eingabe- bzw. Ausgabemodulen, bestehend aus einem auf einem Träger festsetzbaren, anreihbaren Bodenteil und einem damit über eine Steckverbindung auch elektrisch verbindbaren Oberteil, wobei die Bodenteile untereinander elektrisch verbindbar sind.

Mehrfachsignalübertragungsgeräte, bei denen die Eingabe-bzw. Ausgabeelemente aus aneinanderreihbaren, auch elektrisch verbindbaren Modulen bestehen, sind in zahlreichen Ausführungsformen bekannt. So ist beispielsweise auf das Weidmüller-Prospektblatt "Moduplex 08.929/4/85" aus April 1985 zu verweisen. Dort sind auf auf Tragschienen aufrastbare Trägerteile aus Isolierstoff alle benötigten Schaltungs- und Steuerungselemente angeordnet, wobei auch bereits für die Weiterleitung der Versorgungsspannung und sonstiger Steuerungsfunktionen Teilelemente der elektrisch/elektronischen Bestückung der einzelnen Module von Modul zu Modul über eine Steckverbindung, bestehend aus Steckverbinder, Buchse und verbindendem Flachbandkabel, verwirklicht ist.

Bei diesem grundsätzlichen Aufbau von Sender- oder Empfängerlinie besteht jedoch abgesehen von dem Problem, daß die genannten Steckverbindungen von Modul zu Modul bei längeren Aneinanderreihungen umständlich zu handhaben sind, das Problem, daß bei Wartungs-, Umstellungs-oder Auswechselarbeiten an einem der Module die zum Ende der Linie hin nachfolgenden Module ebenfalls von der Strom- und Spannungsversorgung abgetrennt sind und damit die von diesen Modulen gesteuerten Maschinen oder Geräte unnötig Stillstandszeiten haben.

Grundsätzlich verhält es sich genauso bei einem durch die DE-36 03 750 A1 bekanntgewordenen Automatisierungsgerät. Dort ist zwar innerhalb der einzelnen Module eine Aufteilung in ein Bodenteil und ein Oberteil betroffen, wobei Bodenteil und Oberteil mechanisch und elektrisch durch Steckverbindung miteinander verbindbar sind. Es handelt sich insoweit der Funktion nach aber bei den einzelnen Modulen praktisch immer jeweils um ein Mutter- und ein Tochterteil, da auch die dortigen auf die Tragschienen aufrastbaren Bodenteile wesentliche Elemente der Schaltung für die von diesem Modul gesteuerte Maschine tragen, insbesondere eine Anpassungsschaltplatine, wobei dann dort die Bodenteile wiederum über Stecker, Buchse und Flachbandkabel unter Einschluß der jeweiligen Schaltungselemente elektrisch untereinander verbindbar sind, so daß bei Wartungs-, Änderungs- und Reparaturarbeiten an denjenigen Schaltungselementen, die dem Bodenteil zugeordnet sind, wieder der Linie nachfolgende Module von der Stromversorgung abgetrennt sind.

Erschwerend kommt dort auch hinzu, daß die Anschlußelemente für die externe Verdrahtung dem jeweiligen Bodenteil zugeordnet sind und damit auch von daher die genannte Probpematik gegeben ist.

Es ist zwar durch die EP 0 004 507 B1 bekanntgeworden, bei einem vergleichbaren Mehrfachsignalübertragungsgerät ausschließlich der Stromversorgung dienende Stromschienen vorzusehen. Die dort gezeigte Lösung ist aber bezüglich Montage, Wartung und Reparatur äußerst umständlich, da gesonderte durchgehende Stromschienen vorgesehen sind, unter denen ein Bodenteil für die Module vorgesehen ist, das eine komplexe Stromführungseinrichtung sowie darüber hinaus Anschlüsse für eine externe Verdrahtung trägt, während über die Oberseite der Stromschienen ein mehrteiliges Moduloberteil montiert ist. Die Anordnung der Anschlüsse für die externe Verdrahtung in den Bodenteilen bringt also weiterhin die eingangs erläuterte Problematik in diesem Bereich mit sich. Man kann dabei im Bedarfsfall die Oberteile der Module mit den Schaltungen abnehmen, ohne die Stromführung im übrigen zu unterbrechen. Bei Wartungs-und Reparaturarbeiten im Sockelbereich aber, also unterhalb der durchgehenden Stromschienen, muß man praktisch die ganze Anodnung ausbauen und auflösen. Durch das Erfordernis, die Bodenteile unter den durchgehenden Stromschienen anzubringen, kann im übrigen von einem flexiblen Bausystem mit einer beliebigen problemlosen Anreihbarkeit von Modulen keine Rede sein.

Der vorliegenden Erfindung liegt von daher die Aufgabe zugrunde, ein Mehrfachsignalübertragungsgerät der gattungsgemäßen Art zu schaffen, das bei Wartungs-, Änderungs- und Reparaturarbeiten an einem der Module die Aufrechterhaltung der Stromversorgung aller übrigen Module der Linie bei baulicher Einfachheit und bequemer Handhabung, bei Anreihbarkeit, Wartung und Umrüstung gewährleistet.

Die erfindungsgemäße Lösung besteht darin, daß den Bodenteilen elektrisch ausschließlich jeweils auf den beiden Anreihseiten für die Kontaktverbindung mit benachbarten Bodenteilen vorstehende Kontaktsätze für die Stromversorgung der Module und für einen Datentransfer der Linie zugeordnet sind, die jeweils elektrisch mit dem Steckverbinder zum Anschließen der den Oberteilen der Module zugeordneten Schaltungen verbunden sind.

Dank dieser Ausgestaltung ist insbesondere elektrisch eine strikte Trennung einerseits zwischen der Stromversorgung, die nur den Bodenteilen zugeordnet ist, und den Schaltungen für die Steuerung der einzelnen geschlossenen Maschinen und Geräte verwirklicht. Durch die Aneinanderreihung der Bodenteile ergibt sich über die Kontaktsätze praktisch eine durch Kontaktverbindung hergestellte Versorgungslinie in Art einer Bus-Leitung für die Module dieser Linie. Wird an irgendeiner Stelle der Linie von irgendeinem der Module das Oberteil zwecks Wartung, Auswechslung oder Umrüstung an der dort befindlichen Schaltung abgenommen, kommt es zu keinerlei Unterbrechung in der Stromversorgung der übrigen Module, da das Bodenteil des betroffenen Modules ja an Ort und Stelle verbleibt und damit über seinen Kontaktsatz die Kontaktverbindung der Linie aufrechterhält. Alle nicht betroffenen Module und damit die von ihnen gesteuerten Maschinen und Aggregate können also weiterhin in Betrieb bleiben. Die Ausgestaltung hat darüber hinaus den Vorteil, daß der Aufbau der Bus-Leitung für die Stromversorgung der Module einer Linie außerordentlich handhabungsbequem praktisch bei der Anreihung der Module auf einem Träger, beispielsweise bei Aufschnappen und Aneinanderreihen auf einer Tragschiene, quasi automatisch über die dabei zustandekommenden Kontaktverbindungen geschieht, ohne daß zusätzlich zum Anreihen das umständliche Handhaben von Steckverbindungen zwischen den aneinandergereihten Bodenteilen erforderlich wäre. Der Fortfall der bislang hierzu benötigten Steckverbindungselemente einschließlich der Flachbandkabelstücke führt darüber hinaus zur Vergrößerung des Platzangebotes für anderweitige Elemente der Schaltung und auch einer etwaigen externen Verdrahtung.

Weitere besondere Ausgestaltungen des erfindungsgemäßen Mehrfachsignalübertragungsgerätes, die insbesondere zweckmäßige, da die Herstellung vereinfachende bauliche Ausgestaltungen sowie die Funktionssicherheit der Kontaktverbindung begünstigen, sind in den Unteransprüchen gekennzeichnet.

Ein Ausführungsbeispiel eines erfindungsgemäßen Mehrfachsignalübertragungsgerätes wird nachstehend unter Bezugnahme auf die beigefügte Zeichnung näher beschrieben. Es zeigen
- Figur 1: ein Mehrfachsignalübertragungsgerät gemäß der Erfindung in perspektivischer vereinfachter Darstellung,
- Figur 2: einen Querschnitt durch zwei aneinandergereihte Bodenteile von Ein- bzw. Ausgabemodulen des Übertragungsgerätes nach Figur 1,
- Figur 3: einen jeweils in dem Bodenteil nach Figur 2 angeordneten Kontaktfedersatz,
- Figur 4: eine Unteransicht des oberen Isolierteiles eines der Bodenteile nach Figur 2 mit den einmontierten Kontaktfedern entsprechend Figur 3.

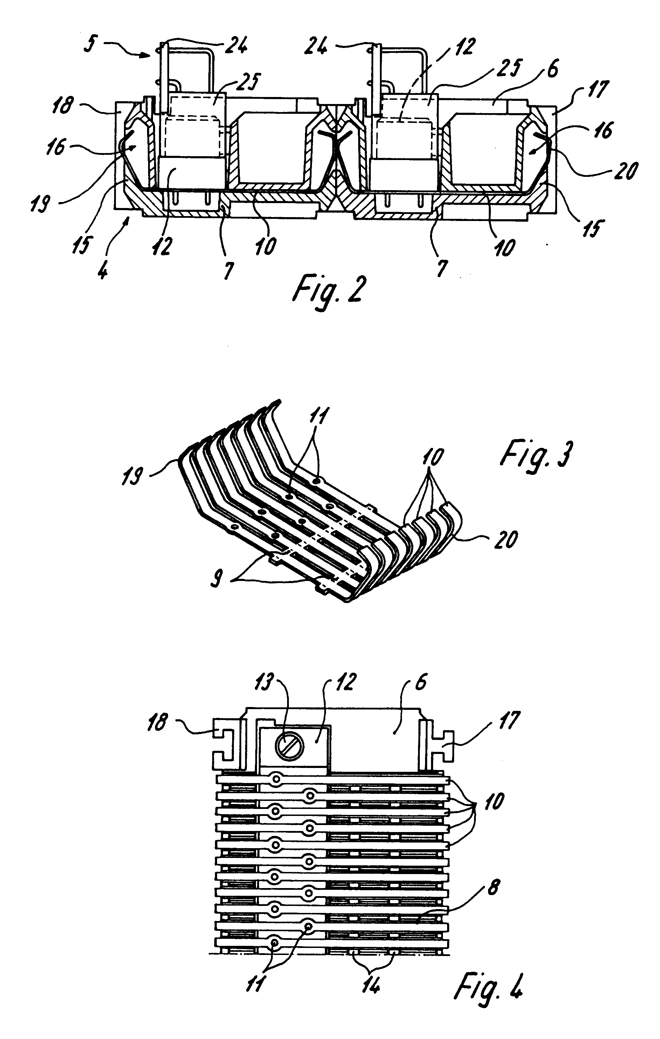

Das Mehrfachsignalübertragungsgerät beinhaltet seinem grundsätzlichen Aufbau nach einen vom Netz speisbaren Sender oder Empfänger 1 sowie einen der jeweiligen Anzahl der zu steuernden Maschinen, Geräte und dergleichen entsprechenden Satz von Ein- oder Ausgabemodulen 2. Sender bzw. Empfänger 1 und die entsprechenden Module werden üblicherweise in Aneinanderreihung auf Trägern, insbesondere genormten Tragschienen 3, aufgerastet. Die einzelnen Module 2 bestehen nun ihrerseits ihrem grundsätzlichen Aufbau nach aus einem Bodenteil 4 und einem damit sowohl elektrisch wie mechanisch verbindbaren Oberteil 5. Erfindungsgemäß sind nun die Bodenteile 4 der Module 2 elektrisch ausschließlich auf die Durchleitung der Stromversorgung und einen Datentransfer einer entsprechenden Modullinie des Mehrfachsignalübertragungsgerätes ausgelegt, dergestalt, daß die Stromversorgung aller Module der Linie auch dann aufrechterhalten bleibt, wenn von dem einen oder anderen Modul 2 einer Anreihung zwecks Wartungs-, Reparatur- oder Umrüstarbeiten das die Schaltung für die Steuerung der betroffenen Maschine beinhaltende Oberteil 5 abgenommen ist. Hierzu sind erfindungsgemäß die Bodenteile 4 der Module 2 jeweils mit Kontaktsätzen, vorzugsweise Kontaktfedersätzen, bestückt, die auf den beiden Anreihseiten des Bodenteiles 4 aus diesem soweit vorstehen, daß bei Anreihung der Bodenteile 4 auf der Tragschiene 3 eine Kontaktverbindung aller Bodenteile 4 aller Module 2 einer Linie geschaffen ist. Eine entsprechende bauliche Ausgestaltung ist in den Figuren 2 bis 4 illustriert. In zweckmäßiger Ausgestaltung besteht nach dieser Ausführungsform das Bodenteil 4 aus einem oberen Isolierteil 6 sowie einem unteren Isolierteil 7. Auf der Unterseite des oberen Isolierteiles 6 befinden sich kammerartige Vertiefungen 8 (Figur 4). Hier wird bei der Montage ein zunächst noch kammerartig ausgebildeter und über Anbindungen 9 zusammenhängender Kontaktfedersatz aus einzelnen Kontaktfedern 10 eingelegt und es erfolgt dabei dann auch gleich die elektrische Verbindung mit dem einen Element der elektrischen Steckverbindung für den Anschluß der dem Oberteil 5 der Module 2 zugeordneten Schaltung für die Steuerung der betroffenen Maschine. Im dargestellten Ausführungsbeispiel werden, wie insbesondere in Figur 4 gezeigt, die einzelnen Kontaktfedern 10 des Kontaktfederkammes über Lötpunkte 11 mit einer im oberen Isolierteil 6 angeordneten Buchsenleiste 12 verbunden. Andere bekannte Anschlußtechniken, beispielsweise die Einpreßtechnik, können ebenfalls zur Anwendung gelangen. Die Buchsenleiste 12 samt Satz der Kontaktfedern 10 wird mittels Schrauben 13 am oberen Isolierteil 6 befestigt. Anstelle der Schraubbefestigung kann auch eine Schnappverbindung eingesetzt werden. Im oberen Isolierteil 6 sind ferner kleine Durchbrüche 14 vorgesehen, durch die hindurch nunmehr in der jetzigen Montagephase die Anbindungen 9 freigestanzt werden können. Dank der geschilderten Ausgestaltung und Art der Montage wird sichergestellt, daß das vorgegebene Rastermaß und die vorgegebene Lage der einzelnen Kontaktfedern 10, insbesondere ihre Parallelität zueinander, während der Montage-und Anschlußvorgänge nicht verändert wird.

Schließlich wird nun das untere Isolierteil 7 mit Hilfe einer an beiden Teilen vorgesehenen Zentrierung paßgerecht positioniert und mit dem oberen Isolierteil 6 fest verbunden, beispielsweise verschweißt oder verklebt.

In weiterer zweckmäßiger Ausgestaltung weist das untere Isolierteil 7 an seinen beiden Anreihseiten kammartig ausgebildete Auflageschultern 15 auf, die in die in dem oberen Isolierteil 6 gebildeten, die Enden der Kontaktfedern 10 aufnehmenden Kontaktkammern 16 eingreifen. Die Anordnung ist dabei so getroffen, daß durch die Montage von unterem und oberen Isolierteil 6 und 7 die einzelnen Kontaktfedern 10 durch die Auflageschultern 15 nach innen in die Kontaktkammern 16 ausgelenkt werden, wobei diese Auslenkung so bemessen ist, daß in der nach der Montage gegebenen Endlage die Kontaktfedern 10 kurz vor der plastischen Verformung stehen.

Man kann dann durch den ersten Kontaktierungsvorgang bei der Anreihung der Module 2 oder auch durch einen speziellen nachfolgenden Kalibriervorgang die Elastizitätsgrenze überschreiten, so daß die einzelne Kontaktfeder in ihrem Einspannungsbereich plastisch verformt wird und damit alle einzelnen Kontaktfedern auf die gleiche Vorspannung gebracht werden. Kontaktkraftschwankungen hervorgerufen durch Lage- sowie Maßtoleranzen der Kontaktfedern und Isolierteile werden dadurch minimiert.

In weiterer Ausgestaltung ist vorgesehen, die in der Anreihung aneinandergrenzenden Bodenteile 4 benachbarter Module 2 nicht nur elektrisch in Kontaktverbindung zu bringen, sondern auch mechanisch miteinander zu verrasten. Hierzu sind im dargestellten Ausführungsbeispiel an den oberen Isolierteilen 6 Führungen 17, 18 vorgesehen, die zweckmäßig hinterschneidende Eingriffsprofile wie T-Profile L-Profile, Schwalbenschwanzprofile und dergleichen haben und die jeweils auf den beiden Anreihseiten komplementär passend zueinander ausgebildet sind, wie es in Figur 4 mit der T-förmigen Führung 17 auf der einen Seite und der entsprechend T-Nuten-förmigen Führung 18 auf der anderen Seite illustriert ist. Mit den Führungen 17, 18 werden die Kontaktkräfte zwischen den in Kontaktverbindung stehenden Bodenteilen 4 aneinandergrenzender Module 2 abgefangen. Sind höhere Kontaktkräfte zu erwarten, können die Führungen auch metallische Stanz- und Biegeteile sein, um entsprechend hohe Kräfte aufnehmen zu können. Die Führungen 17, 18 dienen ferner dazu, die genaue Lage der aneinandergrenzenden Bodenteile 4 der Module 2 zueinander festzulegen, so daß Toleranzschwankungen im Bodenteilbereich aber auch in den noch zu beschreibenden weiteren Rahmenteilen benachbarter Module sich nicht nachteilig auf die Positionierung auswirken können.

In weiterer zweckmäßiger Ausgestaltung haben, wie insbesondere aus den Figuren 2 und 3 ersichtlich, die einzelnen Kontaktfedern 10 an ihren beiden kontaktgebenden Enden unterschiedlich geformte Kontaktbereiche 19, 20, und zwar einerseits einen etwa kreisförmig ausgebildeten Kontaktbereich 19 sowie andererseits einen planflächig ausgebildeten Kontaktbereich 20. Dank dieser Ausgestaltung entsteht auch bei einem etwaigen Höhenversatz benachbarter Bodenteile 4 zueinander, verursacht durch Fertigungs- und Lagetoleranzen, eine sichere Kontaktierung bei der angestrebten Kontaktverbindung von Bodenteil zu Bodenteil.

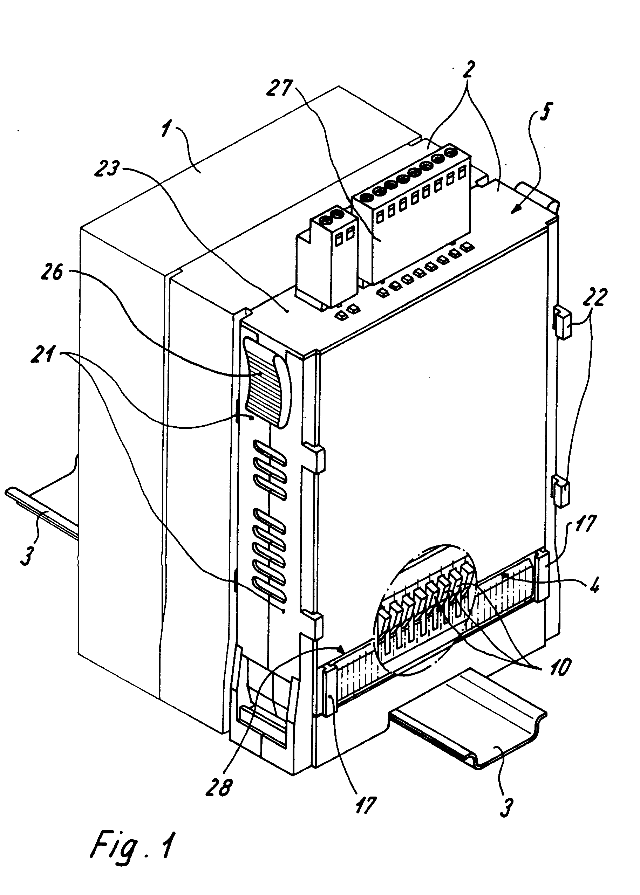

Im dargestellten Ausführungsbeispiel wird das in sich geschlossene Bodenteil 4 noch in zwei gleichartige, nach oben vorstehende Rahmenschalen 21 eingelegt und durch Verrasten dieser Rahmenschalen 21 gehalten. Für die Anreihung benachbarter Module 2 befinden sich an den Rahmenschalen 21 für die Vorzentrierung und Grobführung Führungsstücke 22, während insoweit die exakte Positionierung, wie bereits geschildert, durch die Führungen 17, 18 an den Bodenteilen 4 erfolgt. Bei dieser Ausgestaltung bestehen die Oberteile 5 der Module im wesentlichen nur aus einer Deckelplatte 23 (Figur 1) und daran befestigten, die Schaltung und alle Schaltelemente aufnehmenden Leiterplatte 24 (Figur 2), die mechanisch und elektrisch mit dem anderen Element der Steckverbindung zum Bodenteil 4, im dargestellten Ausführungsbeispiel also mit einer der Buchsenleiste 12 entsprechenden Steckerleiste 25 verbunden ist. Mit der Deckelplatte 23 sind ferner Griffstücke 26 verbunden und auf der Deckelplatte 23 befinden sich auch gegebenenfalls die Anschlußstücke 27 für eine externe Verdrahtung.

In den Rahmenschalen 21 sind ferner Führungen (nicht dargestellt) zum zielgerechten Einbringen des Oberteiles 5, insbesondere also der Leiterplatte 24, vorgesehen, dergestalt, daß auch die Steckerleiste 25 exakt positioniert in die Buchsenleiste 12 eingesteckt werden kann.

Da bei der in Figur 1 dargestellten Ausführungsform die Rahmenschalen 21 auf die kontaktgebenden Seiten der Bodenteile 4 übergreifen, sind in den Rahmenschalen 21 an entsprechender Stelle Fenster 28 für die Kontaktbereiche der Kontaktfedern 10 vorgesehen.

Die Bodenteile 4 tragen schließlich unterseitig entweder angeformt oder als Sonderteile daran befestigt, die üblichen Montagefüße (nicht dargestellt) jeweils zur Aufrastung auf die Tragschienen 3.

Abweichend vom vorstehend beschriebenen Ausführungsbeispiel ist es auch möglich, die Oberteile der Module als geschlossene, mit eigenem Gehäuse versehene Boxen auszubilden, die dann unterseitig fußartige Führungsstücke oder dergleichen haben, die in entsprechende Aussparungen von Bodenteilen eingreifen und darin verrastet werden können. Bei einer derartigen Ausgestaltung werden die Bodenteile dann nicht mit Rahmenschalen versehen.

## Patentansprüche

1. Mehrfachsignalübertragungsgerät, mit einem vom Netz speisbaren Sender bzw. Empfänger (1) und Ein- bzw. Ausgabemodulen (2), bestehend aus einem auf einem Träger (3) festsetzbaren, anreihbaren Bodenteil (4) und einem über eine Steckverbindung (12, 25) auch elektrisch damit verbindbaren Oberteil (5), wobei die Bodenteile (4) untereinander elektrisch verbindbar sind, **dadurch gekennzeichnet**, daß den Bodenteilen elektrisch ausschließlich jeweils auf den beiden Anreihseiten für die Kontaktverbindung mit benachbarten Bodenteilen (4) vorstehend Kontaktsätze (10) für die Stromversorgung der Module (2) und für einen Datentransfer zugeordnet sind, die elektrisch mit dem Steckverbindungselement (12) zum Anschließen der Oberteile (5) der Module (2) verbunden sind.

2. Mehrfachsignalübertragungsgerät nach Anspruch 1, dadurch gekennzeichnet, daß in den Bodenteilen (4) sie von Anreihseite zu Anreihseite durchquerende Kontaktfedersätze (10) angeordnet sind.

3. Mehrfachsignalübertragungsgerät nach Anspruch 1 oder 2, dadurch gekennzeichnet, daß die Bodenteile (4) aus einem oberen (6) und einem unteren (7) Isolierteil zusammengesetzt sind, in dem einen Isolierteil (6) auf seiner dem anderen Isolierteil (7) zugewandten Seite kammartige Vertiefungen (8) vorgesehen sind und in diese ein zunächst noch über Anbindungen (9) kammartig ausgebildeter Kontaktfedersatz (10) eingesetzt ist, wobei in dem Isolierteil (6) Durchbrüche (14) für die Freistanzung der Anbindungen (9) nach der Montage vorgesehen sind.

4. Mehrfachsignalübertragungsgerät nach Anspruch 3, dadurch gekennzeichnet, daß in dem mit den kammartigen Vertiefungen (8) versehenen Isolierteil (6) seitliche Kontaktkammern (16) vorgesehen sind, während in dem anderen Isolierteil (7), in die Kontaktkammern (16) vorstehende Auflageschultern (15) vorgesehen sind, mit denen die Kontaktbereiche (19, 20) der Kontaktfedern (10) eindrückbar sind.

5. Mehrfachsignalübertragungsgerät nach Anspruch 4, dadurch gekennzeichnet, daß die Auflageschultern (15) so bemessen sind, daß nach der Montage die Kontaktfedern (10) so weit in die Kontaktkammern (16) ausgelegt sind, daß sie kurz vor Überschreiten der Elastizitätsgrenze stehen.

6. Mehrfachsignalübertragungsgerät nach einem oder mehreren der vorhergehenden Ansprüche, dadurch gekennzeichnet, daß die Kontaktbereiche (19, 20) der einzelnen Kontaktfedern (10) auf den beiden Anreihseiten unterschiedlich gestaltet sind, wobei auf einer der Seiten der Kontaktbereich (20) als plane Fläche ausgebildet ist.

7. Mehrfachsignalübertragungsgerät nach einem oder mehreren der vorhergehenden Ansprüche, dadurch gekennzeichnet, daß an den Bodenteilen (4) auf den beiden Anreihseiten jeweils komplementäre, bei benachbarten Bodenteilen (4) der Anreihung ineinandergreifende Führungen (17, 18) vorgesehen sind.

8. Mehrfachsignalübertragungsgerät nach einem oder mehreren der vorhergehenden Ansprüche, dadurch gekennzeichnet, daß das Oberteil (5) sowohl die Schaltung (24) für die Steuerung der Maschine einschließlich des anderen Steckverbindungselementes (25) für die Steckverbindung mit dem Bodenteil (4) sowie etwaige Anschlußstücke (27) für die externe Verdrahtung trägt.

9. Mehrfachsignalübertragungsgerät nach einem oder mehreren der vorhergehenden Ansprüche, dadurch gekennzeichnet, daß die Bodenteile (4) der Module (2) zwischen zwei miteinander verrasteten Rahmenschalen (21) für die Aufnahme der Oberteile (5) angeordnet ist.

10. Mehrfachsignalübertragungsgerät nach Anspruch 9, dadurch gekennzeichnet, daß bei die Bodenteile (4) seitlich übergreifenden Rahmenschalen (21) in diesen Fenster (28) für den Durchtritt der Kontaktbereiche (19, 20) der Kontaktfedern (10) vorgesehen sind.

## Claims

1. A multiple signal transmission device having a transmitter or receiver (1) respectively which can be supplied from the mains system and input or output modules (2) respectively comprising a bottom portion (4) which can be arranged in a row and can be fixed on a carrier (3), and a top portion (5) which can also be electrically connected thereto by way of a plug connection (12, 25), wherein the bottom portions (4) can be electrically connected together, characterised in that electrically associated with the bottom portions are contact sets (10) projecting exclusively on each of the two sides of the row for contact connection to adjacent bottom portions (4), for the current supply for the modules (2) and for a data transfer, which are electrically connected to the plug connecting element (12) for connection of the top portions (5) of the modules (2).

2. A multiple signal transmission device according to claim 1 characterised in that arranged in the bottom portions (4) are contact spring sets (10) which extend through the bottom portions from one side of the row to the other.

3. A multiple signal transmission device according to claim 1 or claim 2 characterised in that the bottom portions (4) are composed of an upper insulating portion (6) and a lower insulating portion (7), comb-like recesses (8) are provided in the one insulating portion (6) on its side towards the other insulating portion (7) and a contact spring set (10) which is initially still of a comb-like configuration by way of tie portions (9) is fitted into said recesses, wherein provided in the insulating portion (6) are openings (14) for punching free the tie portions (9) after assembly.

4. A multiple signal transmission device according to claim 3 characterised in that lateral contact chambers (16) are provided in the insulating portion (6) which is provided with the comb-like recesses (8) while provided in the other insulating portion (7) are support shoulders (15) which project into the contact chambers (16) and with which the contact regions (19, 20) of the contact springs (10) can be pressed in.

5. A multiple signal transmission device according to claim 4 characterised in that the support shoulders (15) are of such a size that after assembly the contact springs (10) are extended into the contact chambers (16) to such a distance that they are just short of exceeding the elastic limit.

6. A multiple signal transmission device according to one or more of the preceding claims characterised in that the contact regions (19, 20) of the individual contact springs (10) are of different configurations on the two sides of the row, the contact region (20) being in the form of a flat surface on one of the sides.

7. A multiple signal transmission device according to one or more of the preceding claims characterised in that provided on the bottom portions (4) on each of the two sides of the row are respective complementary guides (17, 18) which engage into each other in respect of adjacent bottom portions (4) of the row.

8. A multiple signal transmission device according to one or more of the preceding claims characterised in that the top portion (5) carries both the circuit (24) for control of the machine including the other plug connection element (25) for the plug connection to the bottom portion (4) and any connecting portions (27) for the external wiring.

9. A multiple signal transmission device according to one or more of the preceding claims characterised in that the bottom portions (4) of the modules (2) is arranged between two frame shells (21) which are latched together for accommodating the top portions (5).

10. A multiple signal transmission device according to claim 9 characterised in that, with frame shells (21) which engage laterally over the bottom portions (4), windows (28) are provided in said frame shells for the contact regions (19, 20) of the contact springs (10) to pass therethrough.

## Revendications

1. Transmetteur multiple de signaux, comportant un émetteur ou un récepteur (1) alimenté par le secteur et des modules d'entrée ou de sortie (2), constitué d'une partie de fond (4) juxtaposable, à fixer sur un support (3) et d'une partie supérieure (5) à relier avec la partie de fond, de manière électrique aussi, par un connecteur à fiches (12, 25), les parties de fond (4) pouvant être reliées électriquement entre elles, caractérisé en ce qu'aux parties de fond sont associés électriquement exclusivement des jeux de contacts (10) faisant saillie chacun sur les deux côtés de juxtaposition, pour la liaison par contact avec des parties de fond (4) voisines, pour l'alimentation électrique des modules (2) et pour un transfert de données, lesquels jeux de contacts sont reliés électriquement avec l'élément de connecteur (12) afin de raccorder les parties supérieures (5) des modules (2).

2. Transmetteur multiple de signaux selon la revendication 1, caractérisé en ce que dans les parties de fond (4) sont prévus des jeux de ressorts de contact (10) les traversant d'un côté de juxtaposition à l'autre.

3. Transmetteur multiple de signaux selon la revendication 1 ou 2, caractérisé en ce que les parties de fond (4) sont constituées d'une pièce d'isolation supérieure (6) et d'une pièce d'isolation inférieure (7), des creux (8) à la manière d'un peigne étant prévus dans une pièce d'isolation (6) sur son côté tourné vers l'autre pièce d'isolation (7) et un jeu de ressorts de contact (10), au départ conçu comme un peigne par des attaches (9), est introduit dans ceux-ci, des ajours (14) étant prévus dans la pièce d'isolation (6), pour la suppression des attaches (9) par découpe, après le montage.

4. Transmetteur multiple de signaux selon la revendication 3, caractérisé en ce que dans la pièce d'isolation (6), pourvue des creux (8) en peigne, il est prévu des chambres de contact (16) latérales, tandis que dans l'autre pièce d'isolation (7), sont prévus des épaulements d'appui (15), faisant saillie dans les chambres de contact (16), grâce auxquels les zones de contact (19, 20) des ressorts de contact (10) peuvent être pressées vers l'intérieur.

5. Transmetteur multiple de signaux selon la revendication 4, caractérisé en ce que les épaulements d'appui (15) ont des dimensions telles qu'après montage les ressorts de contact (10) sont placés suffisamment loin dans les chambres de contact (16) pour qu'ils se trouvent juste sur le point de dépasser la limite d'élasticité.

6. Transmetteur multiple de signaux selon une ou plusieurs des revendications précédentes, caractérisé en ce que les zones de contact (19, 20) des différents ressorts de contact (10) ont des formes différentes sur les deux côtés de juxtaposition, la zone de contact (20) étant une surface plane, sur l'un des côtés.

7. Transmetteur multiple de signaux selon une ou plusieurs des revendications précédentes, caractérisé en ce qu'il est prévu sur les parties de fond (4), sur chacun des deux côtés de juxtaposition, des guides (17, 18) complémentaires, s'engageant les uns dans les autres lorsque les parties de fond (4) de la rangée sont adjacentes.

8. Transmetteur multiple de signaux selon une ou plusieurs des revendications précédentes, caractérisé en ce que la partie supérieure (5) porte le circuit (24) pour la commande de la machine y compris l'autre élément de connecteur à fiches (25) pour la connexion avec la partie de fond (4), ainsi que d'éventuelles pièces de raccordement (27) pour le câblage externe.

9. Transmetteur multiple de signaux selon une ou plusieurs des revendications précédentes, caractérisé en ce que les parties de fond (4) des modules (2) sont placées entre deux coquilles de cadre (21), accrochées l'une à l'autre, pour le logement des parties supérieures (5).

10. Transmetteur multiple de signaux selon la revendication 9, caractérisé en ce qu'il est prévu, dans les coquilles de cadre (21), recouvrent latéralement les parties de fond (4), des fenêtres (28) pour le passage des zones de contact (19, 20) des ressorts de contact (10).
